# EUROPEAN PATENT APPLICATION

(11) **EP 4 783 238 A1**
(43) Date of publication of application: **29.07.2026**
(21) Application number: 24893276.6
(22) Date of filing: 11.11.2024
(51) Int. Cl.: H01L 23/31

(54) **PACKAGING MODULE AND MANUFACTURING METHOD THEREFOR, POWER SUPPLY MODULE AND ELECTRONIC DEVICE**

(30) Priority: 22.11.2023 CN 202311567364
(71) Applicant: HUAWEI TECHNOLOGIES CO., LTD., Shenzhen 518129 (CN)
(72) Inventor: LUO, Yu, Shenzhen, Guangdong 518129 (CN); ZHOU, Jian, Shenzhen, Guangdong 518129 (CN); DING, Yonghuan, Shenzhen, Guangdong 518129 (CN)
(74) Representative: MERH-IP Matias Erny Reichl Hoffmann Patentanwälte PartG mbB
(86) International application number: PCT/CN2024/131183
(87) International publication number: WO 2025/108118

(57) **Abstract**

This application provides a package module and a manufacturing method therefor, a power supply module, and an electronic device. The package module includes a magnetic energy storage layer, where the magnetic energy storage layer is made of a magnetic material, and the magnetic energy storage layer includes a first surface and a second surface that are disposed opposite to each other; a trace layer, where the trace layer includes a first layer, a second layer, and connectors, the first layer is disposed on the first surface of the magnetic energy storage layer, the second layer is disposed on the second surface of the magnetic energy storage layer, and the connector penetrates the magnetic energy storage layer and is separately connected to the first layer and the second layer; and a chip, where the chip is disposed on a side of the magnetic energy storage layer, and the chip is electrically connected to the first layer or the second layer. In this application, the magnetic energy storage layer and the trace layer serve as a bearing platform of the package module, and load the chip, to avoid use of a conventional bearing platform made of a material like resin or ceramics and an independent magnetic energy storage component. The package module in this application has advantages of miniaturization, high efficiency, and high heat dissipation.

## Description

This application claims priority to Chinese Patent Application No. 202311567364.3, filed with the China National Intellectual Property Administration on November 22, 2023 and entitled "PACKAGE MODULE AND MANUFACTURING METHOD THEREFOR, POWER SUPPLY MODULE, AND ELECTRONIC DEVICE", which is incorporated herein by reference in its entirety.

### TECHNICAL FIELD

This application relates to the field of chip packaging technologies, and specifically, to a package module and a manufacturing method therefor, a power supply module, and an electronic device.

### BACKGROUND

With development of electronic technologies, performance of electronic products is required to be increasingly high, and sizes are required to be increasingly small and thin. Therefore, high-density integration and miniaturization of a package structure of the electronic product are a trend of future development.

A system-in-package SiP (system-in-package) module is a single standard package that implements specific functions by preferably assembling a plurality of active electronic elements with different functions and other components such as optional passive components, to form a system or subsystem. Usually, the SiP module needs to combine a chip and a plurality of other passive components to form a high-density module. High density increases heat density of the module exponentially, and greatly reduces heat dissipation effect of the module. In addition, a bearing platform made of a material like resin or ceramics needs to be disposed, and an independent magnetic energy storage component needs to be used, to serve as a bearing platform of the SiP module. Consequently, a volume of the module is still too large to meet a requirement.

### SUMMARY

In view of this, this application provides a package module and a manufacturing method therefor, a power supply module, and an electronic device, to improve a size of the package module, and improve heat dissipation effect and efficiency of the package module.

According to a first aspect, embodiments of this application provide a package module, including:
a magnetic energy storage layer, where the magnetic energy storage layer is made of a magnetic material, and the magnetic energy storage layer includes a first surface and a second surface that are disposed opposite to each other;
a trace layer, where the trace layer includes a first layer, a second layer, and connectors, the first layer is disposed on the first surface of the magnetic energy storage layer, the second layer is disposed on the second surface of the magnetic energy storage layer, and the connector penetrates the magnetic energy storage layer and is separately connected to the first layer and the second layer; and
a chip, where the chip is disposed on a side that is of the first layer and that is away from the magnetic energy storage layer, and the chip is electrically connected to the first layer.

In the foregoing solution, in the package module in this application, the magnetic energy storage layer made of the magnetic material is used as a magnetic core, and the magnetic energy storage layer and the trace layer are combined to implement an inductor function. In addition, the magnetic energy storage layer and the trace layer serve as a bearing platform of the package module, and load the chip, to avoid use of a conventional substrate made of a material like resin or ceramics, and greatly reduce a volume in the module. In addition, the chip is arranged on a side of the first layer, that is, the chip is exposed in the package module, and heat generated by the chip can be directly dissipated to the outside, thereby greatly improving a heat dissipation capability of the module. In addition, the chip is electrically connected to the first layer, so that the trace layer can be configured to implement the inductor function, and can also implement electrical interconnection in the package module. Moreover, there is no obstacle between the chip and the first layer, so that a power path of the module is vertically arranged, thereby reducing a trace loss and improving efficiency of the module.

In this application, the magnetic energy storage layer and the trace layer serve as the bearing platform of the module, and the chip is disposed on a side of the magnetic energy storage layer, so that a size of the package module is determined by sizes of the magnetic energy storage layer, the trace layer, and the chip. Usually, the sizes of the trace layer and the chip are fixed, in other words, in this application, the size (a length, a width, and a height) of the magnetic energy storage layer may be customized based on an actual inductance requirement, to design the size of the package module, so that the package module can be miniaturized to a maximum extent.

In some feasible implementations, the trace layer is of an integrally formed structure.

In the foregoing solution, the trace layer of the integrally formed structure is distributed inside and on the surface of the magnetic energy storage layer. In this way, the inductor function can be strengthened, and mechanical strength of an inductor can be strengthened, so that the module can continuously operate for a long time in a large-current environment, and has low power.

In some feasible implementations, the package module further includes a passive element, and the passive element is disposed inside and/or on a surface of the magnetic energy storage layer.

In the foregoing solution, the passive element may be an integrated passive element or an independent passive element. The independent passive element includes a resistive element and a capacitive element. In this application, the passive element is disposed inside and/or on the surface of the magnetic energy storage layer, so that functions of the module can be enhanced and improved, and high density of the package module is implemented. In addition, the passive element inside the magnetic energy storage layer can further implement miniaturization of the module while ensuring heat dissipation performance of the package module.

In some feasible implementations, the chip is a die, the package module further includes a plastic packaging component, and the plastic packaging component covers at least the die and the first surface of the magnetic energy storage layer.

In the foregoing solution, when the chip used in the package module is the die, the plastic packaging component is disposed on the die and the surface of the magnetic energy storage layer, so that the die can be protected from being affected by an external harsh environment, and an overall voltage withstand capability of the module can be improved.

In some feasible implementations, the first layer has a patterned structure, and the second layer has a patterned structure.

In the foregoing solution, the first layer and the second layer have patterned structures, which indicates that both the first layer and the second layer have a solid part and a hollow part. The solid part is configured to implement electrical interconnection of the module, and the hollow part is configured to implement electrical isolation, to avoid a short circuit of the package module, and improve security of using the package module.

In some feasible implementations, the chip is a packaged chip, the package module further includes a solder mask layer, the solder mask layer is disposed on the first surface and the second surface of the magnetic energy storage layer, the solder mask layer has a patterned structure, the solder mask layer located on the first surface of the magnetic energy storage layer and the first layer are staggered, and the solder mask layer located on the second surface of the magnetic energy storage layer and the second layer are staggered; or
the chip is the die, the package module further includes a solder mask layer, the solder mask layer is disposed on the second surface of the magnetic energy storage layer, the solder mask layer has a patterned structure, and the solder mask layer located on the second surface of the magnetic energy storage layer and the second layer are staggered.

In the foregoing solution, the solder mask layer is also referred to as a green solder mask layer, and can prevent bridging of conductive solder between various electronic elements on the package module, and avoid the short circuit of the module. For the die, the plastic packaging component for protection needs to be arranged on the die. Therefore, the solder mask layer only needs to be disposed on the second surface of the magnetic energy storage layer. For the packaged chip, the chip has a protection structure. Therefore, the solder mask layer is disposed on both the first surface and the second surface of the magnetic energy storage layer. The solder mask layer and the first layer are staggered, and the solder mask layer and the second layer are staggered. This helps reduce a height of the module, and facilitates the miniaturization of the package module.

In some feasible implementations, a magnetic shield layer is disposed between a part of the connectors and the magnetic energy storage layer.

In the foregoing solution, the part of the connectors is configured to conduct the trace layer on two sides of the magnetic energy storage layer, and the magnetic shield layer is disposed between the part of the connectors and the magnetic energy storage layer, so that an electrical connection between the connector and the first layer and an electrical connection between the connector and the second layer can be ensured, and electromagnetic interference of the magnetic energy storage layer to the part of the connectors can be avoided.

In some feasible implementations, an adhesive layer is disposed between the chip and the trace layer.

In the foregoing solution, the adhesive layer is configured to fasten the chip, so that a connection between the chip and the trace layer can be strengthened, and stability of an overall structure of the module can be improved.

In some feasible implementations, a thickness of the magnetic energy storage layer is greater than or equal to 0.3 mm.

In the foregoing solution, the thickness of the magnetic energy storage layer in this application may be specifically 0.3 mm, 0.5 mm, 0.8 mm, 1 mm, 2 mm, 3 mm, 4 mm, 5 mm, or the like. The thickness of the magnetic energy storage layer in this application can be adjusted in a large range, and a small thickness can be implemented. This facilitates the miniaturization of the package module, and the thickness of the magnetic energy storage layer can be designed based on the actual inductance requirement of the module.

In some feasible implementations, a thickness of the first layer is greater than or equal to 0.01 mm; and/or a thickness of the second layer is greater than or equal to 0.01 mm.

In the foregoing solution, the thickness of the first layer in this application may be specifically 0.01 mm, 0.02 mm, 0.05 mm, 0.08 mm, 0.1 mm, 0.15 mm, 0.2 mm, 0.3 mm, 0.4 mm, 0.5 mm, or the like, and the thickness of the second layer in this application may be specifically 0.01 mm, 0.02 mm, 0.05 mm, 0.08 mm, 0.1 mm, 0.15 mm, 0.2 mm, 0.3 mm, 0.4 mm, 0.5 mm, or the like. The thicknesses of the first layer and the second layer in this application can be adjusted in large ranges, and small thicknesses can be implemented. This facilitates the miniaturization of the package module.

According to a second aspect, embodiments of this application further provide a method for manufacturing a package module. The manufacturing method includes the following steps:
forming a second layer and a plurality of connectors, where the connectors are vertically disposed on a surface of the second layer;
forming a magnetic energy storage layer, where the magnetic energy storage layer and the connector are alternately disposed on the surface of the second layer, the magnetic energy storage layer is made of a magnetic material, and the magnetic energy storage layer includes a first surface and a second surface that are disposed opposite to each other;
forming a first layer that covers the connector and the first surface of the magnetic energy storage layer; and
arranging a chip on a side that is of the first layer and that is away from the magnetic energy storage layer, and electrically connecting the chip to the first layer.

In the foregoing solution, in this application, the plurality of connectors and the second layer are first formed; then the magnetic energy storage layer is formed at the second layer, so that the magnetic energy storage layer and the plurality of connectors are alternately disposed; and finally, the first layer that covers the second layer and the magnetic energy storage layer is formed, to form a complete trace layer. The trace layer covers and penetrates the magnetic energy storage layer to implement an inductor function, and serves as a bearing platform of the package module as a whole, thereby greatly reducing a volume of the package module. In addition, the chip is arranged on a side of the first layer, that is, the chip is exposed in the package module, and heat generated by the chip can be directly dissipated to the outside, thereby greatly improving a heat dissipation capability of the module. In addition, the chip is electrically connected to the first layer, so that the trace layer can be configured to implement the inductor function, and can also implement interconnection in the package module. Moreover, there is no obstacle between the chip and the first layer, so that a power path of the module is vertically arranged, thereby reducing a trace loss and improving efficiency of the module.

In some feasible implementations, the manufacturing method further includes: arranging a passive element at the second layer, where the passive element is electrically connected to the second layer; and/or
arranging the passive element at the first layer, where the passive element is electrically connected to the first layer.

In the foregoing solution, the passive element is arranged at the second layer, that is, the passive element is arranged inside the package module. This facilitates miniaturization of the package module. The passive element is arranged at the first layer, that is, both the passive element and the chip are arranged at the first layer. This improves distribution density of components in the package module, and facilitates miniaturization and high density of the package module. It may be understood that, when the passive element is arranged at the second layer, the passive element needs to be disposed before the magnetic energy storage layer is formed.

In some feasible implementations, the chip is a die, and the manufacturing method further includes: forming a plastic packaging component that covers at least the chip and the first surface of the magnetic energy storage layer.

In the foregoing solution, the plastic packaging component that covers at least the chip and the first surface of the magnetic energy storage layer is formed, so that the die can be protected from being affected by an external harsh environment, and an overall voltage withstand capability of the module can be improved.

In some feasible implementations, the manufacturing method further includes: patterning the first layer and the second layer.

In the foregoing solution, the first layer and the second layer are patterned, so that the first layer and the second layer form patterned structures, to be specific, both the first layer and the second layer have a solid part and a hollow part. The solid part is configured to implement electrical interconnection of the module, and the hollow part is configured to implement electrical isolation, to avoid a short circuit of the package module, and improve security of using the package module.

In some feasible implementations, the chip is the die, and the manufacturing method further includes: forming a solder mask layer on the second surface of the magnetic energy storage layer, where the solder mask layer has a patterned structure, and the solder mask layer located on the second surface of the magnetic energy storage layer and the second layer are staggered; or
the chip is a packaged chip, and the manufacturing method further includes: forming a solder mask layer on the first surface and the second surface of the magnetic energy storage layer, where the solder mask layer has a patterned structure, the solder mask layer located on the first surface of the magnetic energy storage layer and the first layer are staggered, and the solder mask layer located on the second surface of the magnetic energy storage layer and the second layer are staggered.

In the foregoing solution, the solder mask layer is also referred to as a green solder mask layer, and can prevent bridging of conductive solder between various electronic elements on the package module, and avoid the short circuit of the module. For the die, the plastic packaging component for protection needs to be arranged on the die. Therefore, the solder mask layer only needs to be disposed on the second surface of the magnetic energy storage layer. For the packaged chip, the chip has a protection structure. Therefore, the solder mask layer is disposed on both the first surface and the second surface of the magnetic energy storage layer. The solder mask layer and the first layer are staggered, and the solder mask layer and the second layer are staggered. This helps reduce a height of the module, and facilitates the miniaturization of the package module.

In some feasible implementations, the manufacturing method further includes: coating a magnetic shield material on an outer surface of a part of the connectors.

In the foregoing solution, the connectors in a part of first through holes are configured to conduct the trace layer on two sides of the magnetic energy storage layer, and the magnetic shield material is coated in the part of the first through holes to form a magnetic shield layer, so that an electrical connection between the connector and the first layer and an electrical connection between the connector and the second layer can be ensured, and electromagnetic interference of the magnetic energy storage layer to the part of the connectors can be avoided. It may be understood that the magnetic shield material is coated on the outer surface of the part of the connectors before the magnetic energy storage layer is formed.

In some feasible implementations, the manufacturing method further includes: coating an adhesive material between the chip and the first layer.

In the foregoing solution, the adhesive material is coated between the chip and the first layer to fasten the chip, so that a connection between the chip and the trace layer can be strengthened, and stability of an overall structure of the module can be improved.

According to a third aspect, embodiments of this application further provide a method for manufacturing a package module, including the following steps:
providing a magnetic energy storage layer, where the magnetic energy storage layer is made of a magnetic material, and the magnetic energy storage layer includes a first surface and a second surface that are disposed opposite to each other;
forming a plurality of first through holes that penetrate the magnetic energy storage layer;
forming a first layer on the first surface of the magnetic energy storage layer, forming a second layer on the second surface of the magnetic energy storage layer, and forming connectors in the first through holes, where two ends of the connector are respectively connected to the first layer and the second layer; and
arranging a chip on a side that is of the first layer and that is away from the magnetic energy storage layer, and electrically connecting the chip to the first layer.

In the foregoing solution, in this application, the magnetic energy storage layer is first provided; the first through holes are formed at the magnetic energy storage layer; and the first layer, the second layer, and the connectors that are connected are formed on the first surface and the second surface of the magnetic energy storage layer and inside the magnetic energy storage layer via the first through holes. The first layer, the second layer, and the connectors that are connected form a trace layer. The trace layer and the magnetic energy storage layer jointly implement an inductor function, and the trace layer is electrically connected to the chip to implement interconnection. In a package module in this application, the chip is loaded at the magnetic energy storage layer without using a conventional substrate made of a material like resin or ceramics, and sizes of the chip, the trace layer, and the magnetic energy storage layer determine a size of the package module, thereby greatly reducing a volume of the module. In addition, the chip is arranged on a side of the first layer, that is, the chip is exposed in the package module, and heat generated by the chip can be directly dissipated to the outside, thereby greatly improving a heat dissipation capability of the module. In addition, there is no obstacle between the chip and the first layer, so that a power path of the module is vertically arranged, thereby reducing a trace loss and improving efficiency of the module.

In some feasible implementations, the manufacturing method further includes: arranging a passive element at the first layer, where the passive element is electrically connected to the first layer.

In the foregoing solution, the passive element is arranged at the first layer, that is, both the passive element and the chip are arranged at the first layer. This improves distribution density of components in the package module, and facilitates miniaturization and high density of the package module.

In some feasible implementations, the chip is a die, and the manufacturing method further includes: forming a plastic packaging component that covers the chip and the first surface of the magnetic energy storage layer.

In the foregoing solution, when the chip is the die, the plastic packaging component that covers at least the chip and the first surface of the magnetic energy storage layer is formed, so that the die can be protected from being affected by an external harsh environment, and an overall voltage withstand capability of the module can be improved.

In some feasible implementations, the manufacturing method further includes: patterning the first layer and the second layer.

In the foregoing solution, the first layer and the second layer are patterned, so that the first layer and the second layer form patterned structures, to be specific, both the first layer and the second layer have a solid part and a hollow part. The solid part is configured to implement electrical interconnection of the module, and the hollow part is configured to implement electrical isolation, to avoid a short circuit of the package module, and improve security of using the package module.

In some feasible implementations, the chip is the die, and the manufacturing method further includes: forming a solder mask layer on the second surface of the magnetic energy storage layer, where the solder mask layer has a patterned structure, and the solder mask layer located on the second surface of the magnetic energy storage layer and the second layer are staggered; or
the chip is a packaged chip, and the manufacturing method further includes: forming a solder mask layer on the first surface and the second surface of the magnetic energy storage layer, where the solder mask layer has a patterned structure, the solder mask layer located on the first surface of the magnetic energy storage layer and the first layer are staggered, and the solder mask layer located on the second surface of the magnetic energy storage layer and the second layer are staggered.

In the foregoing solution, the solder mask layer is also referred to as a green solder mask layer, and can prevent bridging of conductive solder between various electronic elements on the package module, and avoid the short circuit of the module. For the die, the plastic packaging component for protection needs to be arranged on the die. Therefore, the solder mask layer only needs to be disposed on the second surface of the magnetic energy storage layer. For the packaged chip, the chip has a protection structure. Therefore, the solder mask layer is disposed on both the first surface and the second surface of the magnetic energy storage layer. The solder mask layer and the first layer are staggered, and the solder mask layer and the second layer are staggered. This helps reduce a height of the module, and facilitates the miniaturization of the package module.

In some feasible implementations, the manufacturing method further includes: coating a magnetic shield material in a part of the first through holes.

In the foregoing solution, the connectors in the part of the first through holes are configured to conduct the trace layer on two sides of the magnetic energy storage layer, and the magnetic shield material is coated in the part of the first through holes to form a magnetic shield layer, so that an electrical connection between the connector and the first layer and an electrical connection between the connector and the second layer can be ensured, and electromagnetic interference of the magnetic energy storage layer to the part of the connectors can be avoided.

In some feasible implementations, the manufacturing method further includes: coating an adhesive material between the chip and the first layer.

In the foregoing solution, the adhesive material is coated between the chip and the first layer to fasten the chip, so that a connection between the chip and the trace layer can be strengthened, and stability of an overall structure of the module can be improved.

According to a fourth aspect, embodiments of this application further provide a power supply module, including:
a trace board layer, where the trace board layer has a second through hole and a third through hole, the trace board layer includes a first surface and a second surface that are disposed opposite to each other, and
a power supply, a power supply chip, and a package module are disposed at the trace board layer, the package module is electrically connected to the power supply via the second through hole, and the package module is electrically connected to the power supply chip via the third through hole;
a first heat sink, where the first heat sink is disposed on a side that is of the power supply chip and that is away from the trace board layer; and
a second heat sink, where the second heat sink is disposed on a side that is of the package module and that is away from the trace board layer, where
the package module includes the package module according to the first aspect, the package module manufactured by using the manufacturing method according to the second aspect, or the package module manufactured by using the manufacturing method according to the third aspect.

In the foregoing solution, because a main body of the package module in this application includes only the magnetic energy storage layer, the trace layer, and the chip, a volume of the package module at the trace board layer is small, and a layout of the power supply module can be optimized, so that the first heat sink and the second heat sink can be disposed in the power supply module in this application, and disposing the first heat sink and the second heat sink in the power supply module can implement bidirectional heat dissipation of the power supply chip, thereby greatly improving heat dissipation effect of the power supply module.

According to a fifth aspect, embodiments of this application provide an electronic device. The electronic device includes the package module according to the first aspect or the package module manufactured by using the manufacturing method according to the second aspect.

According to the solution provided in embodiments of this application, in the package module, use of a conventional bearing platform made of a material like resin or ceramics and an independent magnetic energy storage component is avoided, the trace layer and the magnetic energy storage layer directly serve as a bearing platform of the package module while implementing an inductor function, and the chip is arranged at the trace layer and is electrically connected to the trace layer. In this way, a volume proportion of the magnetic energy storage layer or the chip in the package module can be increased, thereby facilitating high integration and miniaturization of the package module. The chip is arranged on a side of the first layer, that is, the chip is exposed in the package module, and heat generated by the chip can be directly dissipated to the outside, thereby greatly improving a heat dissipation capability of the module. In addition, there is no obstacle between the chip and the first layer, so that a power path of the module is vertically arranged, thereby reducing a trace loss and improving efficiency of the module. The package module in this application can implement high-density miniaturization, high efficiency, and a strong heat dissipation capability, thereby having a promising application prospect.

### BRIEF DESCRIPTION OF DRAWINGS

To describe technical solutions in embodiments of this application more clearly, the following briefly describes accompanying drawings for embodiments. It is clear that the accompanying drawings in the following descriptions show merely some embodiments of this application, and a person of ordinary skill in the art may derive other drawings from these accompanying drawings without creative efforts.
FIG. 1 is a diagram of a cross-sectional structure of a first package module in a conventional technology 1 according to an embodiment of this application;
FIG. 2 is a diagram of a cross-sectional structure of a second package module in a conventional technology 2 according to an embodiment of this application;
FIG. 3 is a diagram of a cross-sectional structure of a package module according to an embodiment of this application;
FIG. 4 is a diagram of a cross-sectional structure of another package module according to an embodiment of this application;
FIG. 5 is a flowchart of manufacturing a package module according to an embodiment of this application;
FIG. 6 is a diagram of a cross-sectional structure of a second layer and connectors according to an embodiment of this application;
FIG. 7 is a diagram of a cross-sectional structure obtained by manufacturing a magnetic energy storage layer at a second layer according to an embodiment of this application;
FIG. 8 is a diagram of a cross-sectional structure obtained by grinding a magnetic energy storage layer to be aligned with an upper surface of connectors according to an embodiment of this application;
FIG. 9 is a diagram of a cross-sectional structure obtained by forming a second layer on surfaces of a magnetic energy storage layer and connectors according to an embodiment of this application;
FIG. 10 is a diagram of a cross-sectional structure obtained by patterning a first layer and a second layer according to an embodiment of this application;
FIG. 11 is a diagram of a cross-sectional structure in which a solder mask layer is formed on a second surface of a magnetic energy storage layer according to an embodiment of this application;
FIG. 12 is a diagram of a cross-sectional structure in which a solder mask layer is formed on a first surface and a second surface of a magnetic energy storage layer according to an embodiment of this application;
FIG. 13 is another flowchart of preparing a package module according to an embodiment of this application;
FIG. 14 is a diagram of a cross-sectional structure of an entire magnetic energy storage layer according to an embodiment of this application;
FIG. 15 is a diagram of a cross-sectional structure in which first through holes are disposed at an entire magnetic energy storage layer according to an embodiment of this application;
FIG. 16 is a diagram of a cross-sectional structure obtained by coating a magnetic shield material in a part of first through holes according to an embodiment of this application;
FIG. 17 is a diagram of a cross-sectional structure in which a trace layer has a first layer of an entire structure and a second layer of an entire structure according to an embodiment of this application;
FIG. 18 is a diagram of a cross-sectional structure obtained by patterning a first layer and a second layer according to an embodiment of this application;
FIG. 19 is a diagram of a cross-sectional structure in which a solder mask layer is formed on a first surface and a second surface of a magnetic energy storage layer according to an embodiment of this application;
FIG. 20 is a diagram of a cross-sectional structure in which a solder mask layer is formed on a second surface of a magnetic energy storage layer according to an embodiment of this application;
FIG. 21 is a diagram of a cross-sectional structure of a package module of a structure manufactured by using a second manufacturing method according to an embodiment of this application;
FIG. 22 is a diagram of a cross-sectional structure of a package module of another structure manufactured by using a second manufacturing method according to an embodiment of this application;
FIG. 23 is a diagram of a cross-sectional structure of a power supply module according to an embodiment of this application; and
FIG. 24 is a diagram of a cross-sectional structure of an electronic device according to an embodiment of this application.

In these figures,
100: first package module;
   101: first substrate;
   102: first chip;
   103: first inductor;
   104: first capacitor;
   105: first resistor;
200: second package module;
   201: second substrate;
   202: second chip;
   203: second inductor;
   204: second capacitor;
10: package module;
   1: chip;
      11: die;
      12: packaged chip;
   2: magnetic energy storage layer;
   3: trace layer;
      31: first layer;
      32: second layer;
         33: connector;
   4: magnetic shield layer;
   5: passive element;
   6: solder mask layer;
   7: plastic packaging component;
      8: first through hole;
20: trace board layer;
   201: second through hole;
   202: third through hole;
30: power supply;
40: power supply chip;
50: first heat sink;
60: second heat sink;
70: capacitor;
1000: electronic device;
1001: housing; and
1002: motherboard.

### DESCRIPTION OF EMBODIMENTS

To better understand technical solutions of this application, the following describes embodiments of this application in detail with reference to accompanying drawings.

It should be noted that described embodiments are merely some rather than all of embodiments of this application. All other embodiments obtained by a person of ordinary skill in the art based on embodiments of this application without creative efforts shall fall within the protection scope of this application.

Terms used in embodiments of this application are merely intended to describe specific embodiments, but not to limit this application. Terms "a", "the", and "this" of singular forms used in embodiments of this application and the appended claims are also intended to include plural forms, unless otherwise specified in the context clearly.

It should be understood that a term "and/or" used in this specification merely describes an association relationship between associated objects, and indicates that three relationships may exist. For example, A and/or B may indicate the following three cases: Only A exists, both A and B exist, and only B exists. In addition, a character "/" in this specification usually indicates an "or" relationship between the associated objects.

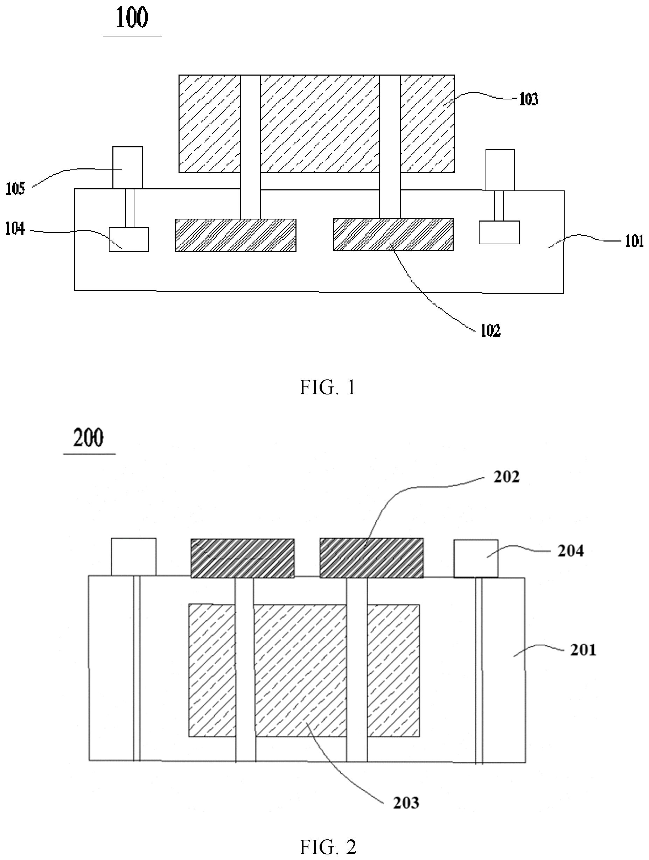

In a related technology, for a layout of a package module, a chip and other passive elements (a capacitor, an inductor, a resistor, and the like) are usually loaded via a substrate made of a material like resin or ceramics. A module may be formed by embedding the chip in the substrate or attaching the chip to a surface of the substrate. FIG. 1 is a diagram of a cross-sectional structure of a first package module 100 according to the conventional technology. The first package module 100 includes a first substrate 101, a first chip 102 and a first capacitor 104 are embedded in the first substrate 101, a first inductor 103 and a first resistor 105 are surface-mounted on a surface of the first substrate 101, and the first chip 102 and the first inductor 103 are disposed opposite to each other, to obtain the first package module 100. In the package module, because the first chip 102 is disposed inside the first substrate 101, a volume proportion of the first chip 102 to the first package module 100 is not high, which reduces utilization of the first chip 102, and causes a size of the module to be large. This is not conducive to miniaturized development of module. In addition, because the first chip 102 needs to dissipate heat to the first substrate 101 and the first inductor 103, the first inductor 103 blocks upward heat dissipation of the first chip 102, and consequently a heat dissipation capability of the module is greatly reduced. In addition, because the first chip 102 is inside the first substrate 101, a temperature of the first substrate 101 is high, which affects selection of another component on the first substrate 101. Moreover, this manufacturing process is complex and costs are high. FIG. 2 is a diagram of a cross-sectional structure of a second package module 200 according to another conventional technology. The second package module 200 includes a second substrate 201, a second inductor 203 is embedded in the second substrate 201, a second capacitor 204 and a second chip 202 are disposed on a surface of the second substrate 201, and the second chip 202 and the second inductor 203 are disposed correspondingly, to obtain the second package module 200. In the package module, because the second inductor 203 is disposed inside the second substrate 201, a volume proportion of the second inductor 203 to the second package module 200 is not high, which reduces utilization of the second inductor 203, and causes performance of the second inductor 203 to be poor. In addition, the second inductor 203 needs to be disposed inside the second substrate 201, which imposes a high precision requirement on the second inductor 203, and an additional auxiliary material further needs to be disposed between the second inductor 203 and the second substrate 201, to prevent the second inductor 203 and the second substrate 201 from being delaminated, which greatly increases manufacturing process difficulty. In addition, a power path between the second inductor 203 and the second chip 202 is long, thereby greatly reducing efficiency of the module.

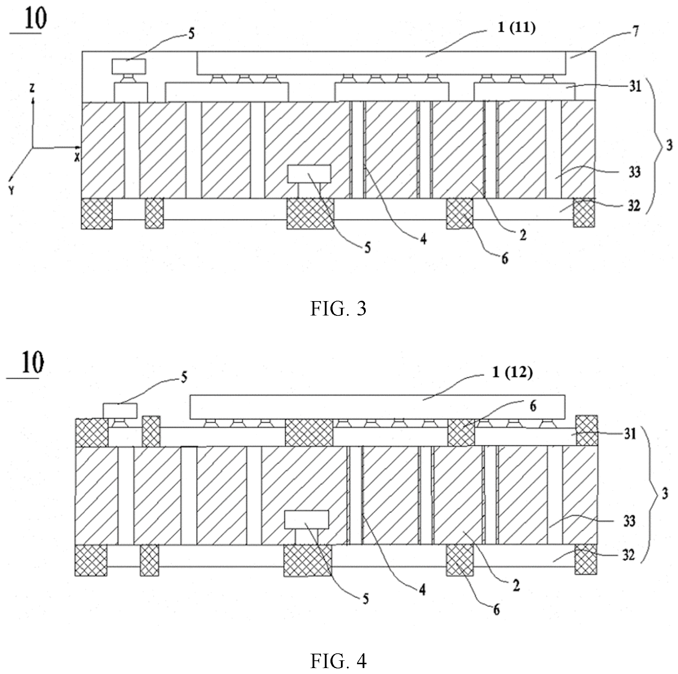

For the foregoing problem, embodiments of this application provide a package module 10 and a manufacturing method therefor, a power supply module, and an electronic device. As shown in FIG. 3, the package module 10 includes a magnetic energy storage layer 2, a trace layer 3, and a chip 1. The magnetic energy storage layer 2 is made of a magnetic material, and the magnetic energy storage layer 2 includes a first surface and a second surface that are disposed opposite to each other. The trace layer 3 includes a first layer 31, a second layer 32, and connectors 33, the first layer 31 is disposed on the first surface of the magnetic energy storage layer 2, the second layer 32 is disposed on the second surface of the magnetic energy storage layer 2, and the connector 33 penetrates the magnetic energy storage layer 2 and is separately connected to the first layer 31 and the second layer 32. The chip 1 is disposed on a side that is of the first layer 31 and that is away from the magnetic energy storage layer 2, and the chip 1 is electrically connected to the first layer 31. In the package module 10 in this application, a conventional substrate made of a material like resin or ceramics does not need to serve as a bearing platform, and the trace layer 3 and the magnetic energy storage layer 2 directly serve as a bearing platform of the module while being combined to implement an inductor function. This helps reduce a volume of the package module 10, and further couples the chip 1 to the trace layer 3 to form the package module, thereby increasing volume proportions of the magnetic energy storage layer 2 and the chip 1 in the module, and improving utilization of the magnetic energy storage layer 2 and the chip 1. In addition, the chip 1 is arranged on a side of the first layer 31, that is, the chip 1 is exposed in the package module 10, and heat generated by the chip 1 can be directly dissipated to the outside, thereby greatly improving a heat dissipation capability of the module. In addition, the chip 1 is electrically connected to the first layer 31, so that the trace layer 3 can be configured to implement the inductor function, and can also implement interconnection in the package module 10. Moreover, there is no obstacle between the chip 1 and the first layer 31, so that a power path of the module is vertically arranged, thereby reducing a trace loss and improving efficiency of the module.

The package module 10 provided in embodiments of this application is used in an electronic device 1000, for example, a common terminal like a mobile phone, a smart watch, or a notebook computer.

The following describes in detail the package module 10 provided in embodiments of this application with reference to specific accompanying drawings.

FIG. 3 is a diagram of a structure of the package module 10 according to an embodiment of this application. The package module 10 includes the magnetic energy storage layer 2, the trace layer 3, and the chip 1. The magnetic energy storage layer 2 is made of the magnetic material, and the magnetic material is magnetic and can generate inductance with the trace layer 3 under a power-on condition. Specifically, the magnetic energy storage layer 2 includes the first surface and the second surface that are disposed opposite to each other. The trace layer 3 includes the first layer 31, the second layer 32, and the connector 33 configured to connect the first layer 31 to the second layer 32, the first layer 31 is disposed on the first surface of the magnetic energy storage layer 2, the second layer 32 is disposed on the second surface of the magnetic energy storage layer 2, and the connector 33 penetrates the magnetic energy storage layer 2 and is separately connected to the first layer 31 and the second layer 32. The chip 1 is disposed on the side that is of the first layer 31 and that is away from the magnetic energy storage layer 2, and the chip 1 is electrically connected to the first layer 31. In other words, the trace layer 3 in this application can partially wrap the magnetic energy storage layer 2 and penetrate the magnetic energy storage layer 2, so that the magnetic energy storage layer 2 and the trace layer 3 jointly function to implement the inductor function. It may be understood that the inductance (Inductance) is an attribute of a closed loop, that is, when a current passing through the closed loop changes, electromotive force appears to resist the change of the current. This is short for an "electromagnetic induction" phenomenon. A structure including both the magnetic energy storage layer 2 and the trace layer 3 is referred to as an "inductor structure" below. In addition, the inductor structure serves as a bearing platform of the chip 1, further serves as a main frame of the package module 10, and is interconnected to the chip 1. In this way, a size of the package module 10 in this application is determined by a size of the inductor structure, so that volume proportions of the inductor structure and the chip 1 in the module are greatly increased, and utilization of the inductor structure and the chip 1 is improved.

The first surface and the second surface of the magnetic energy storage layer are not limited in this application, and it only indicates that the first layer 31 and the second layer 32 are located on two different and opposite surfaces of the magnetic energy storage layer 2. In other words, the chip 1 may be disposed at the first layer 31, or may be disposed at the second layer 32, and in this application, only an example in which the chip 1 is disposed at the first layer 31 is used for description.

In some feasible implementations, the magnetic energy storage layer 2 is made of the magnetic material, and the magnetic material may be, for example, a ferromagnetic material, a nickel-zinc ferromagnetic material, and a manganese-zinc magnetic material. The ferromagnetic material is mainly obtained by adding an insulating agent and a bonding agent to pure iron powder, and is obtained through extrusion molding. The ferromagnetic powder has high saturation flux density, and can be used in a power-type magnetic ring inductor. The nickel-zinc ferromagnetic material absorbs electromagnetic energy by using a magnetic loss and an electrical loss, to absorb an interference electromagnetic wave. The nickel-zinc ferromagnetic material has high surface resistance, and can be used in a medium- and high-frequency circuit. The manganese-zinc magnetic material has high initial magnetic permeability, high saturation flux density, and a low loss, and is usually used in a magnetic-ring common-mode inductor and the like. The magnetic material is not limited in this application, and may be selected based on a specific requirement of the package module 10.

Optionally, there are a plurality of connectors 33, and specifically, may be two, three, five, seven, or the like. This is not limited in this application. Preferably, to strengthen an interconnection function of the trace layer 3, more than three connectors 33 are disposed. As shown in FIG. 3, the inductor structure may be considered as a three-layer structure stacked in a first direction. The first-layer structure includes the first layer 31, and the second-layer structure includes the connector 33 and a magnetic energy storage block that are alternately disposed in a second direction. A plurality of magnetic energy storage blocks form the magnetic energy storage layer 2, and the connectors 33 may be considered as a plurality of conductor columnar structures that are vertically inserted into the magnetic energy storage layer. The third-layer structure includes the second layer 32. The first direction is a thickness direction of the package module 10, or may be a thickness direction of the chip 1, namely, a Z-axis direction shown in FIG. 3. The second direction is perpendicular to the first direction, and the second direction is an extension direction along the first layer 31 or an extension direction along the second layer 32, namely, an X-axis direction shown in FIG. 3.

Optionally, the trace layer 3 is of an integrally formed structure. In a manufacturing process of the package module 10 in this application, the connected trace layer 3 may be formed on the first surface, the second surface, and the inside of the magnetic energy storage layer 2 through electroplating, electroless plating, or the like, so that the trace layer 3 is of the integrally formed structure. In addition, the inductor function can be strengthened. Moreover, the magnetic energy storage layer 2 is disposed inside the trace layer 3, that is, the trace layer 3 serves as the bearing platform of the package module 10, and the integrally formed trace layer 3 can enhance overall mechanical strength of the module.

In some feasible implementations, in the package module 10 in this application, the connector 33 penetrates the magnetic energy storage layer 2, so that the connector 33 is in direct contact with the magnetic energy storage layer 2. A part of the connectors 33 needs to connect the first layer 31 to the second layer 32, to conduct the trace layer 3 and avoid electromagnetic interference caused by the magnetic energy storage layer 2 to the connectors 33. Therefore, as shown in FIG. 3, a magnetic shield layer 4 is disposed between the part of the connectors 33 and the magnetic energy storage layer 2. The magnetic shield layer 4 is a layer structure between the connector 33 and the magnetic energy storage layer 2, the magnetic shield layer 4 is circumferentially disposed around a surface of the connector 33, the magnetic shield layer 4 is prepared by using a magnetic shield material, and a material with high magnetic permeability is selected as the magnetic shield material, for example, permalloy.

In some feasible implementations, still as shown in FIG. 3, the first layer 31 has a patterned structure, and the second layer 32 has a patterned structure. In other words, the first layer 31 has a hollow part and a solid part on the first surface of the magnetic energy storage layer 2, and the second layer 32 has a solid part and a hollow part on the second surface of the magnetic energy storage layer 2. In a preparation process, the entire first layer 31 and the entire second layer 32 may be first prepared, then the first layer 31 and the second layer 32 are patterned by using a mask method or through laser processing, so that the first layer 31 and the second layer 32 each have the patterned structure of the hollow part and the solid part. It may be understood that a pattern of the patterned structure may be specifically designed based on an electrical connection trace of the package module 10, and the patterned structure is not specifically limited in this application. The patterned structures of the first layer 31 and the second layer 32 may be the same or different.

In some feasible implementations, the chip 1 is disposed on the side that is of the first layer 31 and that is away from the magnetic energy storage layer 2, and the chip 1 is electrically connected to the first layer 31. In this application, the first layer 31 is electrically connected to the chip 1, to implement electrical interconnection between the chip 1 and the inductor structure. In addition, a distance between the first layer 31 and the chip 1 is short. This helps shorten the power path between the inductor structure and the chip 1, reduce the trace loss, and improve the efficiency of the module.

In this application, the chip 1 is a semiconductor with an integrated circuit inside. Details are as follows:
Based on a mounting manner of the chip 1, the chip 1 includes two types: a face-up chip and a flip chip. A structure of the face-up chip is sequentially as follows from top to bottom: an electrode, a P-type semiconductor layer, a light emitting layer, an N-type semiconductor layer, and a substrate, where heat generated at a PN junction in the structure needs to pass through the substrate before being conducted to a heat sink, and poor thermal conductivity of the substrate leads to poor thermal conductivity of the structure, which reduces light emitting efficiency and reliability of the chip 1. The chip 1 of the flip structure is sequentially as follows from top to bottom: a substrate, an N-type semiconductor layer, a light emitting layer, a P-type semiconductor layer, and an electrode. Compared with the face-up structure, in this structure, heat generated at a PN junction can be directly conducted to a heat sink without passing through the substrate. In this way, the structure has good heat dissipation performance, and the light emitting efficiency and the reliability of the chip 1 are high. In addition, in the chip 1 of the flip structure, both a p-electrode and an n-electrode are located on a bottom surface, to avoid blocking of emergent light, and the light emitting efficiency of the chip is high. Moreover, a distance between electrodes of the flip chip 1 is long. This can reduce a short-circuit risk caused by electrode metal migration. Preferably, the chip 1 is the FC flip chip 1. In a preparation process of the flip chip 1, a conductive bump is manufactured on a surface of a side of the die 11 by using an under bump metalization (UBM, under bump metalization) process. Specifically, sputtering, evaporation, electroless plating, and the like may be performed on a metal material to form a bump-like structure on the surface of the side of the chip 1, and the chip 1 is connected to the first layer 31 via the conductive bump, to implement an electrical connection between the chip 1 and the first layer 31. This avoids a problem that a layout is disordered and redundant space of the package module 10 is occupied because the chip 1 is connected to the first layer 31 by using wires. Optionally, a material for making the conductive bump includes any one of copper, gold, silver, aluminum, molybdenum, and titanium.

The chip 1 includes two types: the die 11 and a packaged chip 12 based on whether the chip is packaged. The die 11 is the chip 1 that is not packaged after a wafer undergoes a dicing test, and there are only press-welding joints used for packaging on the die. In the packaged chip 12, internal circuits of the die 11 are connected to package pins by using gold wires, and are led out via a housing for wrapping the die 11. In some embodiments, the chip 1 in this application is the die 11. As shown in FIG. 3, the package module 10 further includes a plastic packaging component 7 that covers at least the chip 1 and the first surface of the magnetic energy storage layer 2. In other words, the plastic packaging component 7 is disposed on the top of the package module 10, to wrap and bury the die 11 usually by using an epoxy molding compound (EMC-Epoxy Molding Compound). In addition, cross-linking curing for formation is performed to obtain the plastic packaging component 7 with a specific structural shape for packaging and protecting the die 11. This helps the die 11 be protected from being affected by an external harsh environment during use, and can improve an overall voltage withstand capability of the module. In some other embodiments, as shown in FIG. 4, the chip 1 in this application is the packaged chip 12. To be specific, the package module 10 in this application includes the packaged chip 12 and the inductor structure that are stacked, the plastic packaging component 7 does not need to be disposed, and the packaged chip 12 is directly exposed to an external environment.

In some feasible implementations, the package module 10 further includes a solder mask layer 6. The solder mask layer 6 is a non-wiring layer at the magnetic energy storage layer 2, and is formed by coating a solder mask in a non-wiring region at the magnetic energy storage layer 2. The solder mask has a specific thickness and hardness, and has specific resistance to acid and alkali. The solder mask includes an ultraviolet (UV) curing solder mask, a thermal curing solder mask, a liquid photosensitive solder mask, a dry film solder mask, and the like, for example, epoxy resin and epoxy acrylic resin. In this application, the solder mask layer 6 may be disposed on the first surface of the magnetic energy storage layer 2, or may be disposed on the second surface of the magnetic energy storage layer 2, or certainly may be disposed on both the first surface and the second surface of the magnetic energy storage layer 2. This is mainly related to a selected type of the chip. Still refer to FIG. 3. For the die 11, because the plastic packaging component 7 is disposed on the first surface of the magnetic energy storage layer 2, the solder mask layer 6 needs to be disposed only on the second surface of the magnetic energy storage layer 2. Still refer to FIG. 4. For the packaged chip 12, the solder mask layer is disposed on both the first surface and the second surface of the magnetic energy storage layer 2.

Optionally, the solder mask layer 6 has a patterned structure, the solder mask layer 6 located on the first surface of the magnetic energy storage layer 2 and the first layer 31 are staggered, and the solder mask layer 6 located on the second surface of the magnetic energy storage layer 2 and the second layer 32 are staggered. In this way, the solder mask layer 6 and the first layer 31 are alternately disposed on the first surface of the magnetic energy storage layer 2, and the solder mask layer 6 and the second layer 32 are alternately disposed on the second surface of the magnetic energy storage layer 2. This can prevent bridging of conductive solder between various electronic elements on the package module 10, avoid a short circuit of the module, reduce a height of the module, and implement miniaturization of the module.

In some feasible implementations, for the package module in which the die 11 is selected, an adhesive layer (the adhesive layer is not shown in the accompanying drawings) is disposed between the die 11 and the trace layer 3. The adhesive layer is filled on peripheral edges of the die 11 and is in contact with the first surface of the magnetic energy storage layer 2. The adhesive layer not only enables the die 11 to be more firmly attached to the first layer 31, to improve connection stability of the chip in the package module 10, but also prevent impurities from entering a region between the chip and the magnetic energy storage layer 2.

Optionally, a material for making the adhesive layer includes a light shielding material. Alternatively, the material for making the adhesive layer includes a light absorbing material. In this way, light shielding effect or light absorbing effect can be achieved, light leakage is avoided in peripheral edge positions in which the chip 1 is connected to the magnetic energy storage layer 2, and interference caused by entry of external light to imaging of the chip 1 can also be avoided.

In some feasible implementations, still as shown in FIG. 3 and FIG. 4, the package module 10 further includes a passive element 5. The passive element 5 may be an integrated passive element or an independent passive element. The independent passive element 5 includes a resistive element and a capacitive element. Based on different preparation processes, the passive element 5 may be mounted on a surface of the package module 10. To be specific, after the magnetic energy storage layer 2 and the trace layer 3 are prepared, the passive element 5 is mounted at the first layer 31 of the trace layer 3, and is electrically connected to the first layer 31. The passive element 5 may alternatively be mounted inside the package module 10. To be specific, the second layer 32 and the connector 33 of the trace layer 3 are first manufactured. Before the magnetic energy storage layer 2 is prepared, the passive element 5 is mounted at the second layer 32 in advance and is electrically connected to the second layer 32, and then, the magnetic energy storage layer 2 is manufactured at the second layer 32. In this way, the passive element 5 can be embedded in the package module 10, to optimize a layout of the package module 10, and facilitate the miniaturization of the package module 10. The passive element 5 in this application is indirectly connected to the chip 1 through the trace layer 3, to enhance a function of the chip 1.

In some feasible implementations, a thickness of the magnetic energy storage layer 2 is greater than or equal to 0.3 mm, and may be specifically 0.3 mm, 0.5 mm, 0.8 mm, 1 mm, 2 mm, 3 mm, 4 mm, 5 mm, or the like. The thickness of the magnetic energy storage layer in this application can be adjusted in a large range, and a small thickness can be implemented. This facilitates the miniaturization of the package module, and the thickness of the magnetic energy storage layer can be designed based on an actual inductance requirement of the module.

In some feasible implementations, that a thickness of the first layer 31 is greater than or equal to 0.01 mm may be specifically 0.01 mm, 0.02 mm, 0.05 mm, 0.08 mm, 0.1 mm, 0.15 mm, 0.2 mm, 0.3 mm, 0.4 mm, 0.5 mm, or the like.

In some feasible implementations, that a thickness of the second layer 32 is greater than or equal to 0.01 mm may be specifically 0.01 mm, 0.02 mm, 0.05 mm, 0.08 mm, 0.1 mm, 0.15 mm, 0.2 mm, 0.3 mm, 0.4 mm, 0.5 mm, or the like.

The thicknesses of the first layer 31 and the second layer 32 in this application can be adjusted in large ranges, and small thicknesses can be implemented. This facilitates the miniaturization of the package module.

The thickness of the package module 10 in this application is greater than 0.4 mm, and is obviously less than that of a package module 10 whose substrate is made of plastic or ceramics in the conventional technology. Compared with the conventional technology, in this embodiment of this application, the package module 10 can be lighter and thinner, and the conventional substrate made of the plastic or the ceramics does not need to be disposed, and the trace layer 3 and the magnetic energy storage layer 2 have a specific bearing capacity while being combined to implement the inductor function, so that a requirement of subsequent module application can be met.

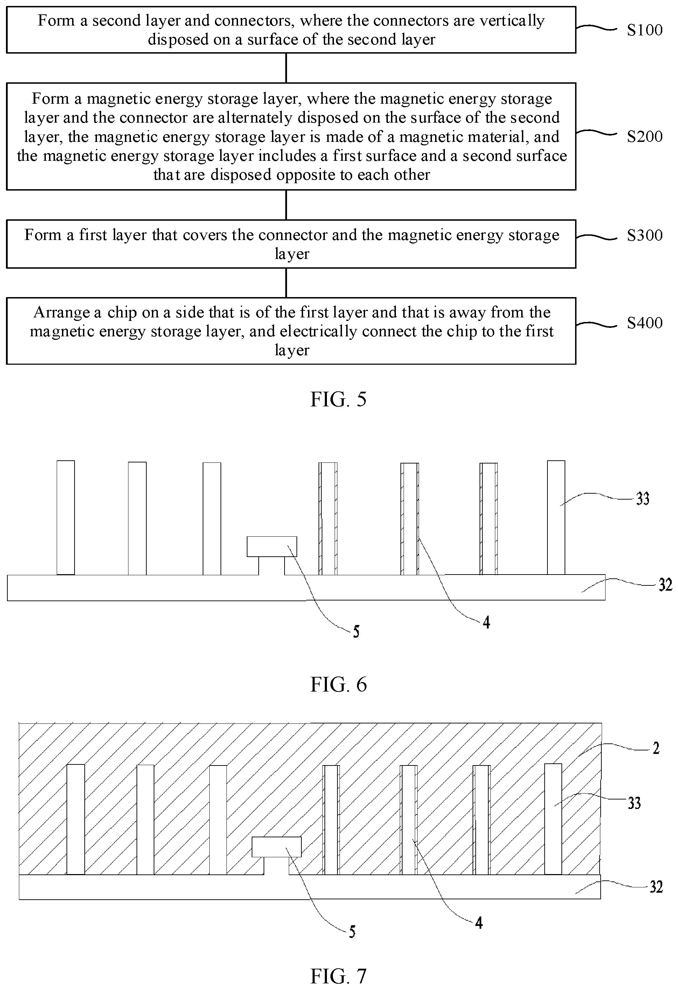

An embodiment of this application further provides a method for manufacturing for the package module 10, to manufacture the package module 10 provided in any embodiment of this application. FIG. 5 is a flowchart of a method for manufacturing a package structure according to an embodiment of this application. As shown in FIG. 5, the manufacturing method includes the following steps:
step S100: Form a second layer 32 and a plurality of connectors 33, where the plurality of connectors 33 are vertically disposed on a surface of the second layer 32;
step S200: Form a magnetic energy storage layer 2, where the magnetic energy storage layer 2 and the connector 33 are alternately disposed on the surface of the second layer 32, and the magnetic energy storage layer 2 is made of a magnetic material;
step S300: Form a first layer 31 that covers the connector 33 and the magnetic energy storage layer 2; and
step S400: Arrange a chip 1 on a side that is of the first layer 31 and that is away from the magnetic energy storage layer 2, and electrically connect the chip 1 to the first layer 31.

According to the manufacturing method provided in this embodiment of this application, the second layer 32 and the connector 33 are first prepared, then the magnetic energy storage layer 2 is manufactured, and finally the first layer 31 that covers the connector 33 and the magnetic energy storage layer 2 is manufactured, to obtain a structure including a trace layer 3 and the magnetic energy storage layer 2. The magnetic energy storage layer 2 is located between the first layer 31 and the second layer 32, and the connector 33 penetrates the magnetic energy storage layer 2, so that the trace layer 3 and the magnetic energy storage layer 2 jointly form an inductor structure, to implement an inductor function. Then, the chip 1 is arranged at the first layer 31, to obtain the package module 10. The inductor structure in this application serves as a bearing platform of the package module 10, so that volumes of the magnetic energy storage layer 2 and the trace layer 3 mainly determine a volume of the package module 10. This greatly increases a volume proportion of the magnetic energy storage layer 2 or the chip 1 in the module. In addition, the chip 1 is exposed in the package module 10, and heat generated by the chip 1 can be directly dissipated to the outside, thereby greatly improving a heat dissipation capability of the module. Besides, the chip 1 is electrically connected to the first layer 31, so that the trace layer 3 can be configured to implement the inductor function, and can also implement electrical interconnection in the package module 10. Moreover, there is no obstacle between the chip 1 and the first layer 31, so that a power path of the module is vertically arranged, thereby reducing a trace loss and improving efficiency of the module. According to the manufacturing method in this application, a process is simple, an implementation degree is high, and high-efficiency, miniaturized, and high heat dissipation package module 10 can be manufactured.

In some feasible implementations, forming the second layer 32 and the connectors 33 in step S100 includes: The second layer 32 is formed by using a mold pressing process, a magnetron sputtering process, an electroplating process, and the like, the connectors 33 are formed at the second layer 32 by using the magnetron sputtering process, the electroplating process, and the like, and the connectors 33 are vertically disposed on the surface of the second layer 32, to obtain a structure shown in FIG. 6. It may be understood that the second layer 32 and the connector 33 may be prepared by using an integrally forming process like magnetron sputtering or electroplating, or may be prepared by using a method in which the second layer 32 is prepared first and then the connector 33 is prepared.

Further, materials for forming the second layer 32 and the connector 33 may be a same conductive material, or may be different conductive materials. The conductive material may be metal, for example, copper (Cu), silver (Ag), stannum (Sn), aluminum (Al), or other metal or metal alloy. The conductive material may alternatively be indium tin oxide (ITO), graphite, graphene, or the like. This is not limited in embodiments of this application.

Further, as shown in FIG. 6, the plurality of connectors 33 are usually disposed, a part of the connectors 33 is configured to conduct the trace layer 3 on two sides of the magnetic energy storage layer 2, and an outer surface of the part of the connectors 33 is coated with a magnetic shield material, to obtain a magnetic shield layer 4 that circumferentially surrounds the connector 33, so that protection can be implemented in advance, so as to avoid electromagnetic interference caused by the subsequently manufactured magnetic energy storage layer to the part of the connectors 33. The connectors 33 that are not coated with the magnetic shield material are configured to serve as wires of the package module 10.

In some feasible implementations, after the second layer 32 and the connectors 33 are formed, the method further includes: disposing a passive element 5 at the second layer 32. A position of disposing the passive element is shown in FIG. 6. There may be one or more passive elements 5, and the passive element 5 is electrically connected to the first layer 31. In other words, in this embodiment, the passive element 5 is disposed inside the package module 10, to facilitate high density and miniaturization of the package module 10. The passive element 5 may be, for example, a resistor or a capacitor.

In some feasible implementations, forming the magnetic energy storage layer 2 in step S200 includes: The magnetic energy storage layer 2 is formed on the surface of the second layer 32 by using the mold pressing process, the magnetron sputtering process, the electroplating process, and the like, to obtain a structure shown in FIG. 7. For example, mold pressing is used as an example to design a shape of the magnetic energy storage layer 2. A corresponding mold is manufactured, and metal magnetic powder is placed in the mold for pressing to obtain the magnetic energy storage layer 2. The metal magnetic powder may be made of a plurality of different types of materials, for example, iron powder, iron-silicon-aluminum magnetic powder, high flux powder, and molypermalloy magnetic powder. Composition of the iron powder core is a combination of extremely fine iron powder and an organic material. Magnetic permeability of the iron powder ranges from 10 to 75. Alloy composition of the iron-silicon-aluminum magnetic powder is 85% iron, 9% silicon, and 6% aluminum. The iron-silicon-aluminum magnetic powder has a low loss and is made of a hard material, and magnetic permeability of the iron-silicon-aluminum magnetic powder may be 26, 60, 75, 90, 125, or the like. The high flux powder is, for example, an iron-nickel magnetic powder core, and alloy powder of the high flux powder may be formed by 50% nickel and 50% iron. The high flux powder core has highest flux density, a loss of the magnetic core is higher than that of the iron-silicon-aluminum magnetic powder and lower than that of the iron powder core, and magnetic permeability of the high flux powder ranges from 14 to 200. Composition of the molypermalloy magnetic powder is 2% molybdenum, 81% nickel, and 17% iron. In the foregoing magnetic powder cores, the molypermalloy magnetic powder has a lowest loss and lowest saturation flux density.

In this embodiment, a first surface and a second surface of the magnetic energy storage layer 2 are any surfaces that are disposed opposite to each other. In some embodiments, the first surface and the second surface are surfaces perpendicular to a thickness direction of the package module 10. The second layer 32 is located on the second surface of the magnetic energy storage layer 2.

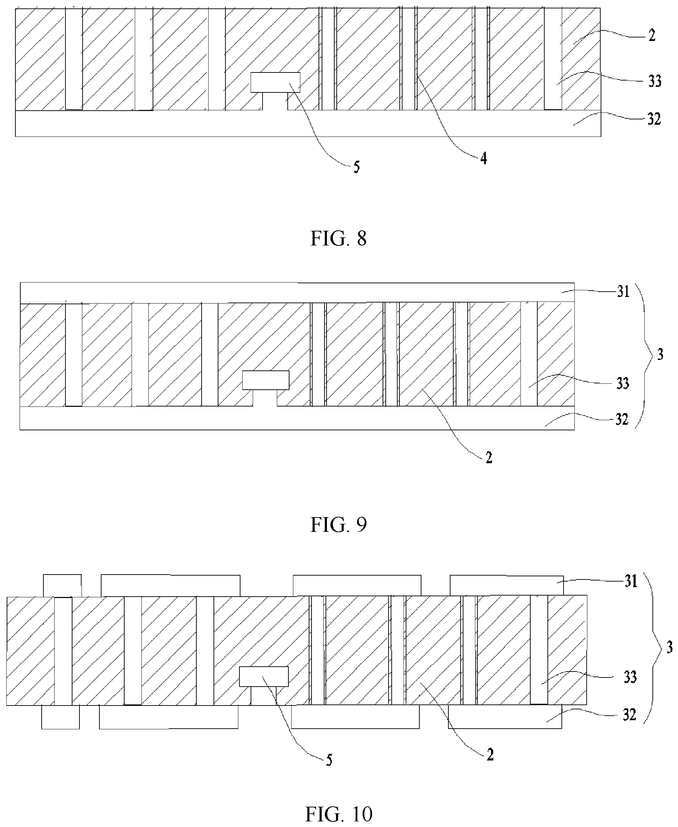

Further, in a process of forming the magnetic energy storage layer 2, an upper surface of the magnetic energy storage layer 2 should be aligned with an upper surface of the connectors 33. If the upper surface of the magnetic energy storage layer 2, after being prepared, covers the connectors 33, the upper surface of the connectors 33 needs to be exposed by using a grinding process, to obtain a structure shown in FIG. 8, so as to ensure a subsequent electrical connection of the connectors 33.

In some feasible implementations, forming the first layer 31 that covers the connector 33 and the magnetic energy storage layer 2 in step S300 includes: The first layer 31 is formed on the first surface of the magnetic energy storage layer 2 by using the mold pressing process, the magnetron sputtering process, the electroplating process, and the like. The first layer 31 and the second layer 32 are parallel to each other and are connected via the connector 33, to form a complete trace layer 3 and obtain a diagram of a structure shown in FIG. 9. Different from the trace layer 3 in the conventional technology, the trace layer 3 in this application can implement an electrical connection function in the package module 10, and can also jointly function with the magnetic energy storage layer 2 to implement the inductor function.

Further, materials for forming the first layer 31 and the second layer 32 may be a same conductive material, or may be different conductive materials. The conductive material may be metal, for example, copper (Cu), silver (Ag), stannum (Sn), aluminum (Al), or other metal or metal alloy. The conductive material may alternatively be indium tin oxide (ITO), graphite, graphene, or the like. This is not limited in embodiments of this application.

Further, after the trace layer 3 is obtained, the first layer 31 and the second layer 32 are patterned, to obtain a structure shown in FIG. 10. In FIG. 10, the first layer 31 includes a solid part and a hollow part, and the solid part and the hollow part are alternately disposed on the first surface of the magnetic energy storage layer 2. The second layer 32 includes a solid part and a hollow part, and the solid part and the hollow part are alternately disposed on the second surface of the magnetic energy storage layer 2.

Specifically, the material of the first layer 31 in a partial region is removed by using a mask method, an etching method, or the like, to obtain the patterned first layer 31, and the material of the second layer 32 in a partial region is removed by using the mask method, the etching method, or the like, to obtain the patterned second layer 32. The first layer 31 and the second layer 32 are patterned, to avoid a short circuit of the package module 10, and improve security of using the package module 10. Certainly, patterning may alternatively be performed in another manner like laser cutting. This is not limited herein in this application.

In some feasible implementations, after step S300, the method further includes: forming a solder mask layer 6 on the first surface and/or the second surface of the magnetic energy storage layer 2, where the solder mask layer 6 has a patterned structure, and is selectively manufactured on the first surface and the second surface of the magnetic energy storage based on a type of the chip 1 selected for the package module 10.

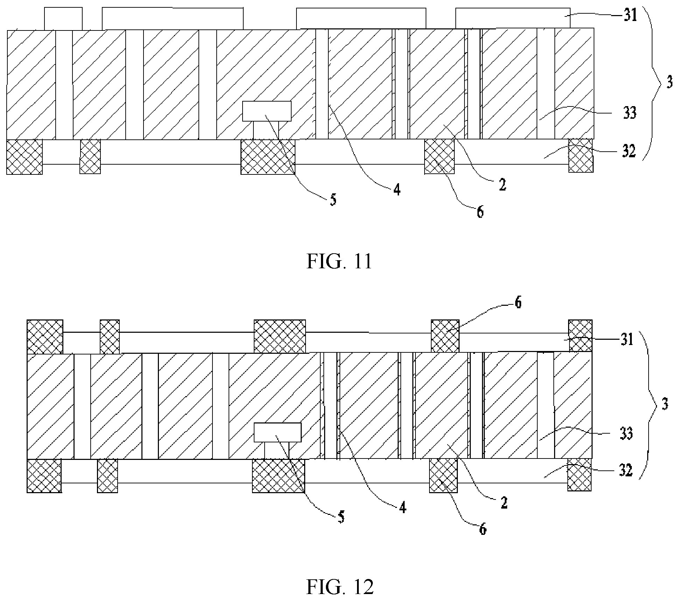

When the chip 1 selected for the package module 10 is a die 11, additional plastic packaging usually needs to be performed on the die 11 to protect the die 11. A plastic packaging component for packaging also covers a part of the magnetic energy storage layer 2 while protecting the die 11. In this case, the solder mask layer 6 does not need to be disposed on a surface that is of the magnetic energy storage layer 2 and that is close to the preset chip 1, that is, the solder mask layer 6 is formed on the second surface of the magnetic energy storage layer 2 by using a process like coating or spraying a solder mask material. More specifically, as shown in FIG. 11, the solder mask material is coated on a gap of the patterned second layer 32 to form the solder mask layer 6. The solder mask layer 6 and the second layer 32 are alternately disposed and are both located on the second surface of the magnetic energy storage layer 2. The solder mask layer 6 can avoid the short circuit of the package module 10, and can further reduce a height of the package module 10, thereby facilitating the miniaturization of the package module 10.

When the chip 1 selected for the package module 10 is a packaged chip 12, the solder mask layer 6 needs to be disposed on both the first surface and the second surface of the magnetic energy storage layer 2. Specifically, the solder mask layer 6 is formed on the first surface and the second surface of the magnetic energy storage layer 2 by using the process like coating or spraying, the solder mask layer located on the first surface of the magnetic energy storage layer 2 and the first layer 31 are alternately disposed, and the solder mask layer located on the second surface of the magnetic energy storage layer 2 and the second layer 32 are alternately disposed, to obtain a structure shown in FIG. 12.

Optionally, the solder mask material includes any one of exposure ink, UV ink, and marking ink.

In some feasible implementations, after step S300, the method further includes: arranging the passive element 5 at the first layer 31, where the passive element 5 is electrically connected to the first layer 31, to enhance a function of the package module 10. There may be one or more passive elements 5. Specifically, the passive element 5 may be a capacitor, a resistor, or the like. It may be understood that, in the manufacturing method described in this embodiment of this application, when the passive element 5 is arranged at the first layer 31, the passive element 5 is disposed on a surface of the package module 10. When the passive element 5 is arranged at the second layer 32, the passive element 5 is disposed inside the package module 10. In this application, a distribution position of the passive element 5 may be set based on an actual requirement, and certainly, the passive element 5 may alternatively be arranged at both the first layer 31 and the second layer 32.

In some feasible implementations, in step S400, the chip 1 is arranged on the side that is of the first layer 31 and that is away from the magnetic energy storage layer 2, and the chip 1 is electrically connected to the first layer 31, to obtain the package module 10.

Specifically, the chip 1 in this application has a conductive bump, the conductive bump is disposed toward the first layer 31, and the chip 1 is electrically connected to the first layer 31 via the conductive bump. In other words, the chip 1 in this application is directly disposed on the inductor structure, so that a power path between the inductor structure and the chip 1 is short, the trace loss can be reduced. In addition, the inductor structure serves as the bearing platform of the chip 1 without disposing a conventional substrate made of a material like resin or ceramics, so that volume proportions of the inductor structure and the chip 1 in the package module 10 can be greatly reduced.

Further, after the chip 1 is arranged on the side that is of the first layer 31 and that is away from the magnetic energy storage layer 2, the method further includes: coating an adhesive material between the first surface of the magnetic energy storage layer 2 and the chip 1, to form an adhesive layer between the chip 1 and the magnetic energy storage layer 2, so as to fasten the chip 1.

Specifically, the adhesive material may be epoxy resin adhesive, UV adhesive, or the like.

Further, as described above, the chip 1 may be the die 11, or may be the packaged chip 12. When the chip 1 is the die 11, after the die 11 is electrically connected to the first layer 31, the plastic packaging component 7 needs to be formed on the first surface of the magnetic energy storage layer 2, to obtain a structure shown in FIG. 3. The plastic packaging component 7 covers the chip 1 and the first surface of the magnetic energy storage layer 2, to protect the chip 1. When the chip is the packaged chip 12, the chip 1 already has a protection structure, and the plastic packaging component 7 does not need to be disposed, to obtain a structure shown in FIG. 4.

Specifically, a plastic packaging material is extruded into a mold cavity by using a transfer molding method, to prepare the plastic packaging component 7, and then the prepared plastic packaging component 7 is placed on the first surface of the magnetic energy storage layer 2, so that the plastic packaging component 7 wraps the chip 1. The plastic packaging component 7 is then bonded to the first surface of the magnetic energy storage layer 2.

The plastic packaging material may be one or a combination of epoxy resin (Epoxy Molding Compound, EMC), polyethylene, polypropylene, polyolefin, polyamide, polyurethane, and the like.

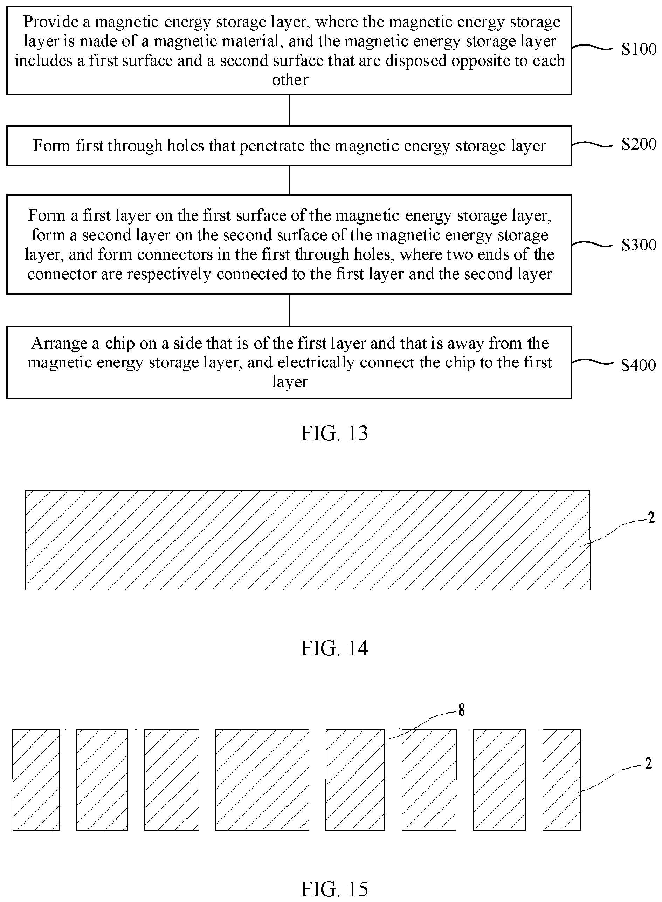

An embodiment of this application further provides a method for manufacturing the package module 10, to manufacture the package module 10 provided in any embodiment of this application. Different from the method for manufacturing the package module 10 provided in this application, the magnetic energy storage layer 2 is first manufactured, and then the trace layer 3 is manufactured. FIG. 11 is a flowchart a method for manufacturing a package structure according to an embodiment of this application. As shown in FIG. 13, the manufacturing method includes the following steps:
step S100: Provide a magnetic energy storage layer 2, where the magnetic energy storage layer 2 is made of a magnetic material, and the magnetic energy storage layer 2 includes a first surface and a second surface that are disposed opposite to each other;
step S200: Form first through holes 8 that penetrate the magnetic energy storage layer 2;
step S300: Form a first layer 31 on the first surface of the magnetic energy storage layer 2, form a second layer 32 on the second surface of the magnetic energy storage layer 2, and form connectors 33 in the first through holes 8, where two ends of the connector 33 are respectively connected to the first layer 31 and the second layer 32; and
step S400: Arrange a chip 1 on a side that is of the first layer 31 and that is away from the magnetic energy storage layer 2, and electrically connect the chip 1 to the first layer 31.

According to the manufacturing method provided in this embodiment of this application, the trace layer 3 does not need to be manufactured step by step, and can be directly formed on the first surface and the second surface of the magnetic energy storage layer 2 and inside the magnetic energy storage layer 2, so that a process can be simplified, and module manufacturing efficiency can be improved.

In some feasible implementations, providing the magnetic energy storage layer 2 in step S100 includes: Metal magnetic powder is pressed by using a mold pressing method to form the magnetic energy storage layer 2, so as to obtain a structure shown in FIG. 14. After pressing is completed, annealing processing needs to be performed on the magnetic energy storage layer 2, to reduce a loss of the magnetic material. Certainly, a commercial metal magnetic core may alternatively be directly purchased for cutting into a required shape.

Specifically, a temperature of the annealing processing should not be lower than 350°C, for example, may be 350°C, 380°C, 400°C, 450°C, or 500°C. Within the limited range, an overall loss of the magnetic material used as an inductor structure can be reduced, and it is ensured that the inductor structure operates under a low temperature.

Specifically, the metal magnetic powder may be made of a plurality of different types of materials, for example, iron powder, iron-silicon-aluminum magnetic powder, high flux powder, and molypermalloy magnetic powder.

In some feasible implementations, in step S200, the first through holes 8 that penetrate the magnetic energy storage layer 2 is formed, to obtain a structure shown in FIG. 15.

The first through hole 8 is space reserved for preparing the trace layer 3 that penetrates the magnetic energy storage layer 2. A plurality of first through holes 8 are usually set, for example, three, five, six, or seven first through holes 8. The first through hole 8 may be formed in a laser drilling manner, or may alternatively be formed in another manner. This is not limited in this application.

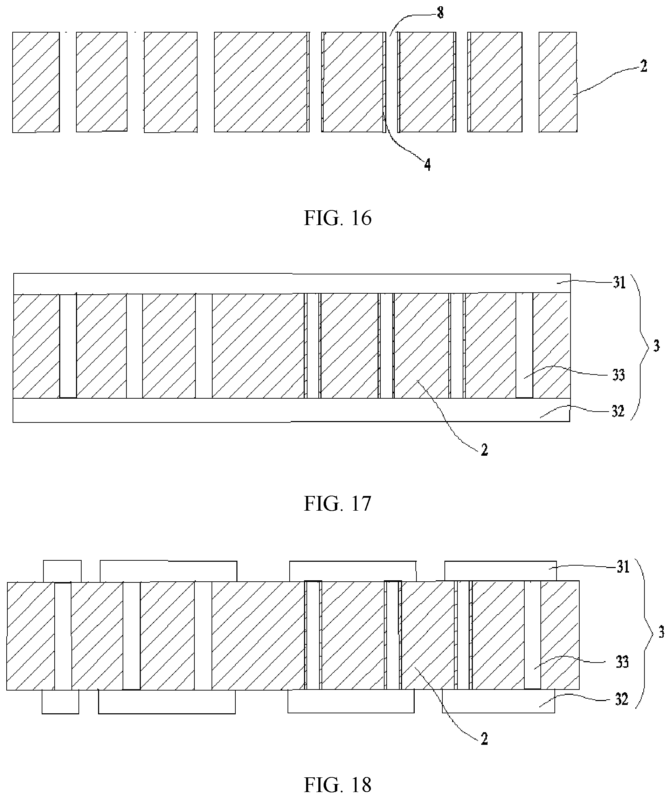

Further, in the plurality of first through holes 8, the connectors 33 need to be subsequently disposed in the first through holes 8. A part of the connectors 33 is configured to implement an electrical connection of the package module 10, and a part of the conductors is configured to conduct the trace layer 3 on two sides of the magnetic energy storage layer 2. Therefore, a magnetic shield material needs to be coated in advance in the first through hole 8 of the connector 33 used to conduct the trace layer 3 on the two sides of the magnetic energy storage layer 2, to form a magnetic shield layer 4 and obtain a structure shown in FIG. 16. This prevents the magnetic energy storage layer 2 from causing electromagnetic interference to the connector 33 in the part of the first through holes 8.

In some feasible implementations, in step S300, the first layer 31 is formed on the first surface of the magnetic energy storage layer 2, the second layer 32 is formed on the second surface of the magnetic energy storage layer 2, and the connectors 33 are formed in the first through holes 8, where the two ends of the connector 33 are respectively connected to the first layer 31 and the second layer 32, to obtain a structure shown in FIG. 17.

Specifically, a conductive material is used to form the first layer 31 on the first surface of the magnetic energy storage layer 2, form the second layer 32 on the second surface of the magnetic energy storage layer 2, and form the connectors 33 in the first through holes 8 by using an electroless plating process, a magnetron sputtering process, an electroplating process, and the like, to obtain the trace layer 3. In this step, the trace layer 3 may be formed by using a one-step process, the process is simple, and manufacturing efficiency is high. Alternatively, the second layer 32 may be first prepared, then the connector 33 may be prepared, and finally the first layer 31 may be prepared in a step-by-step manner.

Further, the conductive material may be metal, for example, copper (Cu), silver (Ag), stannum (Sn), aluminum (Al), or other metal or metal alloy. The conductive material may alternatively be indium tin oxide (ITO), graphite, graphene, or the like. This is not limited in embodiments of this application.

In some feasible implementations, after the trace layer 3 is obtained, the first layer 31 and the second layer 32 are patterned, to obtain a structure shown in FIG. 18. In FIG. 18, the first layer 31 includes a solid part and a hollow part, and the second layer 32 includes a solid part and a hollow part.

Specifically, a material of the first layer 31 in a partial region is removed by using a mask method, an etching method, or the like, to obtain the first layer 31 of a patterned structure, and a material of the second layer 32 in a partial region is removed by using the mask method, the etching method, or the like, to obtain the second layer 32 of a patterned structure. The first layer 31 and the second layer 32 of the patterned structures are disposed, so that a short circuit of the package module 10 can be avoided, and security of using the package module 10 can be improved. Certainly, patterning may alternatively be performed in another manner like laser cutting. This is not limited herein in this application.

In some feasible implementations, after step S300, the method further includes: forming a solder mask layer 6 on the first surface and/or the second surface of the magnetic energy storage layer 2, where the solder mask layer 6 has a patterned structure, and is selectively manufactured on the first surface and the second surface of the magnetic energy storage based on a type of the chip 1 selected for the package module 10.

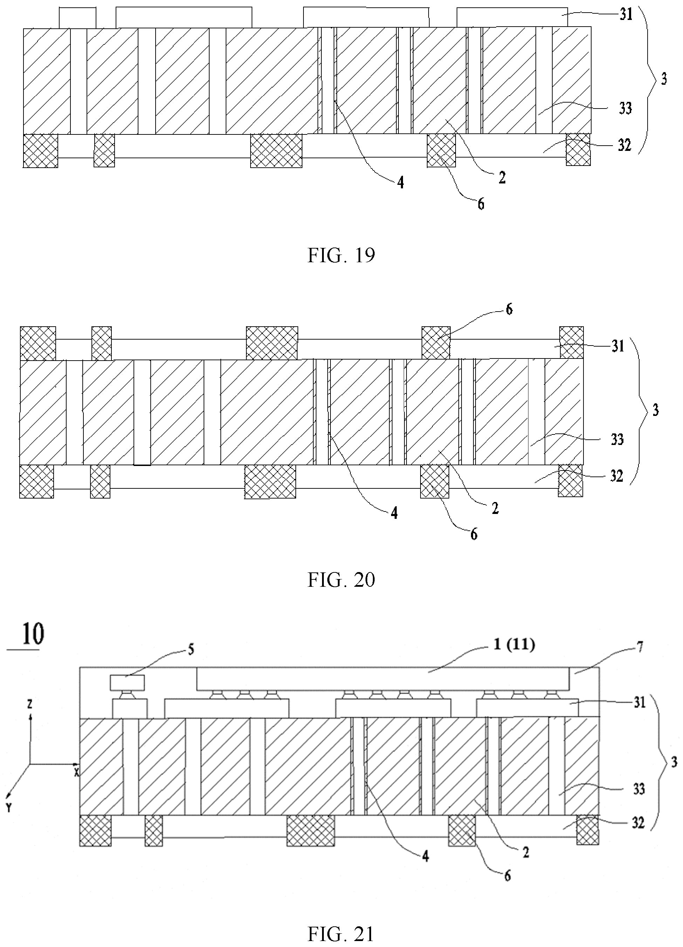

When the chip 1 selected for the package module 10 is a die 11, additional plastic packaging usually needs to be performed on the die 11 to protect the die 11. Plastic packaging also covers a part of the magnetic energy storage layer 2 while protecting the die 11. In this case, the solder mask layer 6 does not need to be disposed on a surface that is of the magnetic energy storage layer 2 and that is close to the preset die 11, that is, the solder mask layer 6 is formed on the first surface of the magnetic energy storage layer 2 by using a process like coating or spraying a solder mask material. More specifically, as shown in FIG. 19, the solder mask material is coated on a gap of the patterned first layer 31 to form the solder mask layer 6. The solder mask layer 6 and the first layer 31 are alternately disposed and are both located on the first surface of the magnetic energy storage layer 2. The solder mask layer 6 can avoid the short circuit of the package module 10, and can further reduce a height of the package module 10, thereby facilitating miniaturization of the package module 10.

When the chip 1 selected for the package module 10 is a packaged chip 12, the solder mask layer 6 needs to be disposed on both the first surface and the second surface of the magnetic energy storage layer 2. Specifically, as shown in FIG. 20, the solder mask layer 6 is formed on the first surface and the second surface of the magnetic energy storage layer 2 by using the process like coating or spraying, the solder mask layer located on the first surface of the magnetic energy storage layer 2 and the first layer 31 are alternately disposed, and the solder mask layer located on the second surface of the magnetic energy storage layer 2 and the second layer 32 are alternately disposed.

Optionally, the solder mask material includes any one of exposure ink, UV ink, and marking ink.

In some feasible implementations, after the trace layer 3 is obtained, a passive element 5 is arranged at the first layer 31, to enhance a function of the package module 10. There may be one or more passive elements 5, and the passive element 5 is electrically connected to the first layer 31. Specifically, the passive element 5 may be a capacitor, a resistor, or the like.

In some feasible implementations, in step S400, the chip 1 is arranged on the side that is of the first layer 31 and that is away from the magnetic energy storage layer 2, and the chip 1 is electrically connected to the first layer 31.

Specifically, the chip 1 in this application has a conductive bump, the conductive bump is disposed toward the first layer 31, and the chip 1 is electrically connected to the first layer 31 via the conductive bump. In other words, the chip 1 in this application is directly disposed on the inductor structure, so that a power path between the inductor structure and the chip 1 is short, a trace loss can be reduced. In addition, the inductor structure serves as a bearing platform of the chip 1 without disposing a conventional substrate made of a material like resin or ceramics, so that a volume proportion of the chip 1 in the package module 10 can be greatly reduced.

Further, after the chip 1 is arranged on the side that is of the first layer 31 and that is away from the magnetic energy storage layer 2, the method further includes: coating an adhesive material between the first surface of the magnetic energy storage layer 2 and the chip 1, to form an adhesive layer between the chip 1 and the magnetic energy storage layer 2, so as to fasten the chip 1.

Specifically, the adhesive material may be epoxy resin adhesive, UV adhesive, or the like.

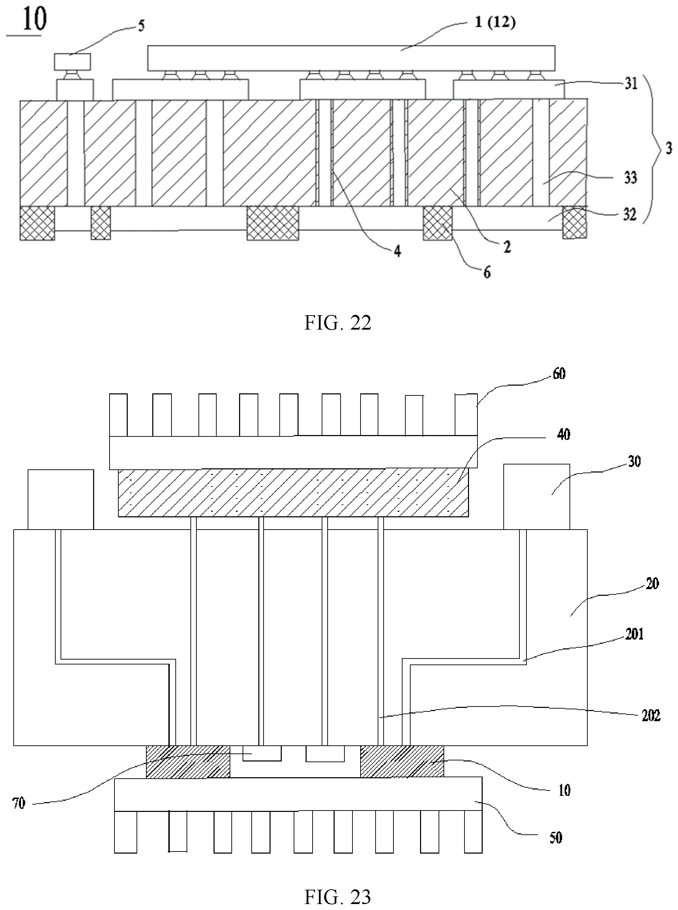

Optionally, as described above, the chip 1 may be the die 11, or may be the packaged chip 12. When the chip 1 is the die 11, after the die 11 is electrically connected to the first layer 31, a plastic packaging layer needs to be formed on the first surface of the magnetic energy storage layer 2. When the chip is the packaged chip 12, the chip 1 already has a protection structure, and a plastic packaging component 7 does not need to be disposed. When the selected chip is the die 11, a diagram of a structure of the package module 10 is shown in FIG. 21. When the selected chip is the packaged chip 12, a diagram of a structure of the package module 10 is shown in FIG. 22.

Specifically, a plastic packaging material is extruded into a mold cavity by using a transfer molding method, to prepare the plastic packaging component 7, and then the prepared plastic packaging component 7 is placed on the first surface of the magnetic energy storage layer 2, so that the plastic packaging component 7 wraps the chip 1. The plastic packaging component 7 is then bonded to the first surface of the magnetic energy storage layer 2.

The plastic packaging material may be one or a combination of epoxy resin (Epoxy Molding Compound, EMC), polyethylene, polypropylene, polyolefin, polyamide, polyurethane, and the like.

Refer to FIG. 23. This application further provides a power supply module. The power supply module includes a trace board layer 20, and a power supply 30, a power supply chip 40, and a package module 10 that are disposed at the trace board layer 20. The trace board layer 20 has a second through hole 201 and a third through hole 202, the power supply 30 is electrically connected to the package module 10 via the second through hole 201, and the power supply chip 40 is electrically connected to the package module 10 via the third through hole 202. In this way, a connection path between the package module 10 and the power supply 30 and a connection path between the package module 10 and the power supply chip 40 are short, a trace loss of the power supply module can be reduced, and efficiency of the power supply module is improved. A second heat sink 60 is arranged on a side that is of the power supply chip 40 and that is away from the trace board layer 20, and a first heat sink 50 is arranged on a side that is of the package module 10 and that is away from the trace board layer 20. Because the package module 10 in this application has a small volume, a volume of the package module 10 at the trace board layer 20 is small. This helps the power supply chip 40 dissipate heat upward via the second heat sink 60, and dissipate heat downward via the first heat sink 50, thereby implementing bidirectional heat dissipation.

In a possible implementation, the trace board layer 20 includes a printed circuit board (PCB) or a flexible printed circuit (FPC). Specifically, the trace board layer 20 includes a substrate and circuit wires formed on the substrate by using a film forming process. The substrate may be a glass substrate, a resin substrate, an aluminum substrate, or the like.

Optionally, the trace board layer 20 includes a first surface and a second surface that are disposed opposite to each other, and the first surface and the second surface are different. In some embodiments, the first surface and the second surface are two adjacent surfaces. In some other embodiments, the first surface and the second surface are two surfaces that are disposed opposite to each other. In some embodiments, still as shown in FIG. 23, the power supply 30 and the power supply chip 40 are disposed at the trace board layer 20 in a face-up manner, that is, the power supply 30 and the power supply chip 40 are arranged on the first surface of the trace board layer 20, and the package module 10 is arranged on the second surface of the trace board layer 20. In some other embodiments, the power supply 30 and the power supply chip 40 may alternatively be flip-mounted at the trace board layer 20, and are soldered to the trace board layer 20 via conductive bump solder balls. In other words, the power supply 30 and the power supply chip 40 are arranged on the second surface of the trace board layer 20, and the package module 10 is arranged on the first surface of the trace board layer 20. The power supply 30 and the power supply chip 40 are electrically connected to the package module 10 in a wire bonding manner.

In a possible implementation, the power supply 30 converts a bus voltage into a direct current required by a load, and can meet requirements of different voltages in the power supply module.

In a possible implementation, the package module 10 is electrically connected to the trace board layer 20 via a second conductive bump, and the package module 10 is connected to the trace board layer 20, so that an input signal may be provided for a substrate layer in the package module 10 via the trace board, and an output signal fed back by the substrate layer is received.

In a possible implementation, the power supply chip 40 is fastened to the trace board layer 20 via pins, and is electrically connected to the trace board layer 20. In this way, the substrate layer in the package module 10 is electrically connected to the trace board layer 20 via the second conductive bump, and the power supply chip 40 is electrically connected to the trace board layer 20 via the pins, to transmit physical information.

In a possible implementation, the first heat sink 50 and the second heat sink 60 are respectively disposed on two sides of the trace board layer 20, so that heat generated by the power supply chip 40 can be dissipated via the second heat sink 60 adjacent to the power supply chip 40, and the heat generated by the power supply chip 40 can further be dissipated via the trace board layer 20 and the first heat sink 50, to improve heat dissipation effect of the power supply chip 40. Heat of the substrate layer in the package module 10 may also be dissipated via the first heat sink 50.

Optionally, the first heat sink 50 is a heat dissipation fin, and the second heat sink 60 is a heat dissipation fin. For example, the first heat sink 50 is an aluminum alloy heat dissipation fin. A material of aluminum alloy has good thermal conductivity, thereby improving heat dissipation effect of the heat sink. In addition, the heat sink may be disposed in a groove shape, to increase a contact area between the heat sink and the air. Certainly, in this application, heat dissipation may alternatively be performed on the power supply module via a heat sink in another form, for example, in an air cooling manner.

In a possible implementation, still as shown in FIG. 23, a third capacitor 70 is further disposed on the second surface of the trace board layer 20, and the third capacitor 70 is electrically connected to the power supply chip 40 in the wire bonding manner.

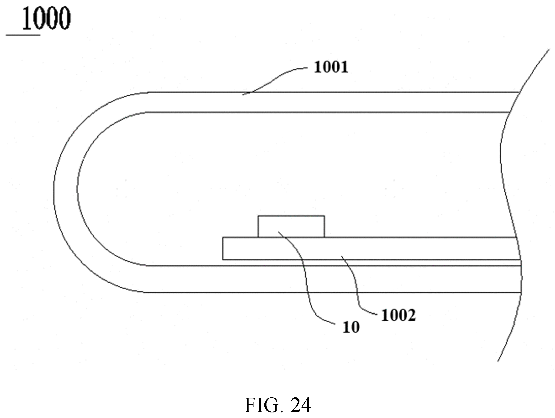

An embodiment of this application provides an electronic device 1000. The electronic device 1000 may be a common terminal like a mobile phone, a tablet computer, or a notebook computer in the conventional technology, and includes the package module or the power supply module in any one of the foregoing embodiments. The package module in this application directly uses the substrate layer and the magnetic energy storage layer 2 as main structures, so that the package module 10 is characterized by miniaturization, a strong heat dissipation capability, and high efficiency. Therefore, a layout of the electronic device can be optimized, and efficiency and heat dissipation performance of the electronic device can be improved. FIG. 24 is a diagram of a structure in which the package module 10 is used in the electronic device 1000 according to this application. The electronic device 1000 includes a housing 1001 and a motherboard 1002 disposed inside the housing 1001. The package module 10 is fastened to the motherboard 1002 and is electrically connected to the motherboard 1002.

Same or similar parts of embodiments of this specification may be referred to each other. Especially, apparatus and terminal embodiments are basically similar to a method embodiment, and therefore are described briefly. For related parts, refer to partial descriptions in the method embodiment.

## Claims

1. A package module, comprising:
a magnetic energy storage layer, wherein the magnetic energy storage layer is made of a magnetic material, and the magnetic energy storage layer comprises a first surface and a second surface that are disposed opposite to each other;
a trace layer, wherein the trace layer comprises a first layer, a second layer, and connectors, the first layer is disposed on the first surface of the magnetic energy storage layer, the second layer is disposed on the second surface of the magnetic energy storage layer, and the connector penetrates the magnetic energy storage layer and is separately connected to the first layer and the second layer; and
a chip, wherein the chip is disposed on a side that is of the first layer and that is away from the magnetic energy storage layer, and the chip is electrically connected to the first layer.

2. The package module according to claim 1, wherein the trace layer is of an integrally formed structure.

3. The package module according to claim 1 or 2, wherein the package module further comprises a passive element, and the passive element is disposed inside and/or on a surface of the magnetic energy storage layer.

4. The package module according to any one of claims 1 to 3, wherein the chip is a die, the package module further comprises a plastic packaging component, and the plastic packaging component covers at least the die and the first surface of the magnetic energy storage layer.

5. The package module according to any one of claims 1 to 4, wherein the first layer has a patterned structure, and the second layer has a patterned structure.

6. The package module according to claim 5, wherein the chip is a packaged chip, the package module further comprises a solder mask layer, the solder mask layer is disposed on the first surface and the second surface of the magnetic energy storage layer, the solder mask layer has a patterned structure, the solder mask layer located on the first surface of the magnetic energy storage layer and the first layer are staggered, and the solder mask layer located on the second surface of the magnetic energy storage layer and the second layer are staggered; or
the chip is the die, the package module further comprises a solder mask layer, the solder mask layer is disposed on the second surface of the magnetic energy storage layer, the solder mask layer has a patterned structure, and the solder mask layer located on the second surface of the magnetic energy storage layer and the second layer are staggered.

7. The package module according to any one of claims 1 to 6, wherein a magnetic shield layer is disposed between a part of the connectors and the magnetic energy storage layer.

8. The package module according to any one of claims 1 to 7, wherein an adhesive layer is disposed between the chip and the trace layer.

9. The package module according to any one of claims 1 to 8, wherein a thickness of the magnetic energy storage layer is greater than or equal to 0.3 mm.

10. The package module according to any one of claims 1 to 9, wherein a thickness of the first layer is greater than or equal to 0.01 mm; and/or
a thickness of the second layer is greater than or equal to 0.01 mm.

11. A method for manufacturing a package module, wherein the manufacturing method comprises the following steps:
forming a second layer and a plurality of connectors, wherein the connectors are vertically disposed on a surface of the second layer;
forming a magnetic energy storage layer, wherein the magnetic energy storage layer and the connector are alternately disposed on the surface of the second layer, the magnetic energy storage layer is made of a magnetic material, and the magnetic energy storage layer comprises a first surface and a second surface that are disposed opposite to each other;
forming a first layer that covers the connector and the first surface of the magnetic energy storage layer; and
arranging a chip on a side that is of the first layer and that is away from the magnetic energy storage layer, and electrically connecting the chip to the first layer.

12. The manufacturing method according to claim 11, wherein the manufacturing method further comprises: arranging a passive element at the second layer, wherein the passive element is electrically connected to the second layer; and/or
arranging the passive element at the first layer, wherein the passive element is electrically connected to the first layer.

13. The manufacturing method according to claim 11 or 12, wherein the chip is a die, and the manufacturing method further comprises: forming a plastic packaging component that covers at least the chip and the first surface of the magnetic energy storage layer.

14. The manufacturing method according to any one of claims 11 to 13, wherein the manufacturing method further comprises: patterning the first layer and the second layer.

15. The manufacturing method according to claim 14, wherein the chip is the die, and the manufacturing method further comprises: forming a solder mask layer on the second surface of the magnetic energy storage layer, wherein the solder mask layer has a patterned structure, and the solder mask layer located on the second surface of the magnetic energy storage layer and the second layer are staggered; or
the chip is a packaged chip, and the manufacturing method further comprises: forming a solder mask layer on the first surface and the second surface of the magnetic energy storage layer, wherein the solder mask layer has a patterned structure, the solder mask layer located on the first surface of the magnetic energy storage layer and the first layer are staggered, and the solder mask layer located on the second surface of the magnetic energy storage layer and the second layer are staggered.

16. The manufacturing method according to any one of claims 11 to 15, wherein the manufacturing method further comprises: coating a magnetic shield material on an outer surface of a part of the connectors.

17. The manufacturing method according to any one of claims 11 to 16, wherein the manufacturing method further comprises: coating an adhesive material between the chip and the first layer.

18. A method for manufacturing a package module, wherein the manufacturing method comprises the following steps:
providing a magnetic energy storage layer, wherein the magnetic energy storage layer is made of a magnetic material, and the magnetic energy storage layer comprises a first surface and a second surface that are disposed opposite to each other;
forming a plurality of first through holes that penetrate the magnetic energy storage layer;
forming a first layer on the first surface of the magnetic energy storage layer, forming a second layer on the second surface of the magnetic energy storage layer, and forming connectors in the first through holes, wherein two ends of the connector are respectively connected to the first layer and the second layer; and
arranging a chip on a side that is of the first layer and that is away from the magnetic energy storage layer, and electrically connecting the chip to the first layer.

19. The manufacturing method according to claim 18, wherein the manufacturing method further comprises: arranging a passive element at the first layer, wherein the passive element is electrically connected to the first layer.

20. The manufacturing method according to claim 18 or 19, wherein the chip is a die, and the manufacturing method further comprises: forming a plastic packaging component that covers the chip and the first surface of the magnetic energy storage layer.

21. The manufacturing method according to any one of claims 18 to 20, wherein the manufacturing method further comprises: patterning the first layer and the second layer.

22. The manufacturing method according to claim 21, wherein the chip is the die, and the manufacturing method further comprises: forming a solder mask layer on the second surface of the magnetic energy storage layer, wherein the solder mask layer has a patterned structure, and the solder mask layer located on the second surface of the magnetic energy storage layer and the second layer are staggered; or
the chip is a packaged chip, and the manufacturing method further comprises: forming a solder mask layer on the first surface and the second surface of the magnetic energy storage layer, wherein the solder mask layer has a patterned structure, the solder mask layer located on the first surface of the magnetic energy storage layer and the first layer are staggered, and the solder mask layer located on the second surface of the magnetic energy storage layer and the second layer are staggered.

23. The manufacturing method according to any one of claims 18 to 22, wherein the manufacturing method further comprises: coating a magnetic shield material in a part of the first through holes.

24. The manufacturing method according to any one of claims 18 to 23, wherein the manufacturing method further comprises: coating an adhesive material between the chip and the first layer.

25. A power supply module, comprising:
a trace board layer, wherein the trace board layer has a second through hole and a third through hole, and
a power supply, a power supply chip, and a package module are disposed at the trace board layer, the package module is electrically connected to the power supply via the second through hole, and the package module is electrically connected to the power supply chip via the third through hole;
a first heat sink, wherein the first heat sink is disposed on a side that is of the power supply chip and that is away from the trace board layer; and
a second heat sink, wherein the second heat sink is disposed on a side that is of the package module and that is away from the trace board layer, wherein
the package module comprises the package module according to any one of claims 1 to 10, the package module manufactured by using the manufacturing method according to any one of claims 11 to 17, or the package module manufactured by using the manufacturing method according to any one of claims 18 to 24.

26. An electronic device, wherein the electronic device comprises the package module according to any one of claims 1 to 10, the package module manufactured by using the manufacturing method according to any one of claims 11 to 17, or the package module manufactured by using the manufacturing method according to any one of claims 18 to 24.
